(19) Europäisches Patentamt
European Patent Office
Office européen des brevets

(11) **EP 4 318 132 A1**

(12) **EUROPEAN PATENT APPLICATION**

(43) Date of publication:
**07.02.2024   Bulletin 2024/06**

(21) Application number: **22188166.7**

(22) Date of filing: **01.08.2022**

(51) International Patent Classification (IPC):
**G03F 7/20** *(2006.01)*        **G03F 9/00** *(2006.01)*

(52) Cooperative Patent Classification (CPC):
**G03F 7/70908; G03F 7/70033; G03F 7/7085;
G03F 7/70925; G03F 9/7096**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ASML Netherlands B.V.
5500 AH Veldhoven (NL)**

(72) Inventors:
- **CARBONE, Ludovico
  5500 AH Veldhoven (NL)**
- **DREISSEN, Mante
  5500 AH Veldhoven (NL)**
- **LEVASIER, Leon, Martin
  5500 AH Veldhoven (NL)**

(74) Representative: **ASML Netherlands B.V.
Corporate Intellectual Property
P.O. Box 324
5500 AH Veldhoven (NL)**

(54) **CONTAMINATION MEASUREMENT**

(57)    A method of determining contamination of an optical sensor in a lithographic apparatus, the method comprising illuminating a pattern on a patterning device using EUV radiation, projecting patterned reflected EUV radiation towards the optical sensor and thereby forming an aerial image of the pattern, and moving the optical sensor relative to the patterned reflected EUV radiation such that an intensity of EUV radiation measured by the optical sensor varies as a function of the position of the optical sensor, wherein the intensity measured by the optical sensor passes through a minimum, and wherein the method further comprises using the measured intensity to measure contamination of the optical sensor.

FIG. 4B

EP 4 318 132 A1

**Description**

FIELD

The present invention relates to measuring contamination of an optical sensor which forms part of a lithographic apparatus.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

When a lithographic substrate is being exposed it is supported by a substrate table. The substrate table may comprise a substrate clamp and a base which holds the substrate clamp. The base may comprise reflective surfaces which allow for interferometric measurement of the position of the substrate table. Over time, contamination may build up on the substrate table. In particular, contamination may build up on areas of the substrate table which are not covered by a substrate during lithographic exposure. The substrate table is provided with a sensor system. The sensor system may be provided in the substrate table base (e.g. radially outward of the substrate clamp). When contamination builds up on an optical sensor of the sensor system this may have a detrimental effect upon the performance of the optical sensor. The substrate table may be cleaned, for example using hydrogen radicals. However, such cleaning takes time, and exposure of lithographic substrates is suspended during cleaning. For this reason it is desirable not to clean the substrate table too often. Conversely however, if cleaning is delayed for too long then the build-up of contamination on the sensors may cause the performance of the lithographic apparatus to deteriorate outside of desirable parameters.

It may be desirable to provide a method and apparatus that overcomes or mitigates one or more problems associated with the prior art.

SUMMARY

According to a first aspect of the present invention, there is provided a method of determining contamination of an optical sensor in a lithographic apparatus, the method comprising illuminating a pattern on a patterning device using EUV radiation, projecting patterned reflected EUV radiation towards the optical sensor and thereby forming an aerial image of the pattern, and moving the optical sensor relative to the patterned reflected EUV radiation such that an intensity of EUV radiation measured by the optical sensor varies as a function of the position of the optical sensor, wherein the intensity measured by the optical sensor passes through a minimum, and wherein the method further comprises using the measured intensity to measure contamination of the optical sensor.

Advantageously, the method provides a direct measurement of contamination in a straightforward manner. Because the contamination is measured directly, instead of estimating the contamination, cleaning to remove the contamination can be performed only when the contamination is at a level such that cleaning is required. This avoids performing cleaning when cleaning is not required (which will happen if cleaning is based on an estimate of contamination). Therefore, cleaning can be performed less frequently. This increases the productivity of the lithographic apparatus. Embodiments of the invention may correct a measurement to take into account the effect of the contamination, e.g. using a known relationship between the thickness of the contamination and a signal output from the optical sensor. The relationship may be determined by performing calibration measurements for various thicknesses of contamination.

A depth of the minimum may be used to measure the contamination of the optical sensor.

The movement of the optical sensor may be generally perpendicular to a direction of the projected EUV radiation.

The method may further comprise using the shape of the measured intensity to obtain information about a cross-sectional shape of the contamination.

The movement of the optical sensor may be generally parallel to a direction of the projected EUV radiation.

The optical sensor may have an area which is greater than an area of the aerial image of an alignment pattern used to perform alignment measurements in connection with the optical sensor.

The pattern which is illuminated for the contamination measurement may be the alignment pattern.

The measurement of the contamination may take into account an intensity of background radiation incident upon the optical sensor.

The measured contamination may be compared with a threshold value.

According to a second aspect of the invention there is provided a lithographic apparatus comprising a patterning device support structure, a projection system, and a substrate table provided with an optical sensor; wherein the lithographic apparatus comprises a processor configured to move the sensing system relative to a projected patterned EUV radiation beam such that an intensity of EUV radiation measured by the optical sensor varies as a function of sensor position and includes a minimum, and wherein the processor is further configured to use the measured intensity to measure contamination of the optical sensor

Advantageously, the lithographic apparatus obtains a direct measurement of contamination in a straightforward manner.

The processor may be configured to use a depth of the minimum to measure the contamination of the optical sensor.

The movement of the optical sensor may be generally perpendicular to a direction of the projected patterned EUV radiation beam.

The processor may be configured to use the shape of the measured intensity to obtain information about a cross-sectional shape of the contamination.

The movement of the optical sensor may be generally parallel to a direction of the projected EUV radiation.

The optical sensor may have an area which is greater than an area of an aerial image of an alignment pattern used to perform alignment measurements in connection with the optical sensor.

The measurement of the contamination may take into account an intensity of background radiation incident upon the optical sensor.

The measured contamination may be compared with a threshold value.

According to a third aspect of the invention there is provided a computer-readable storage medium comprising instructions which, when executed by a processor of a computing device cause the computing device to perform the method of the first aspect of the invention.

According to a fourth aspect of the invention there is provided a computing device comprising a processor and memory, the memory storing instructions which, when executed by the processor cause the computing device to perform the method of the first aspect of the invention.

Features of different aspects of the invention may be combined together.

## BRIEF DESCRIPTION OF THE DRAWINGS

Embodiments of the invention will now be described, by way of example only, with reference to the accompanying schematic drawings, in which:

- Figure 1 schematically depicts a lithographic system comprising a lithographic apparatus and a radiation source;
- Figures 2A and 2B depict a sensor system which forms part of the lithographic apparatus;
- Figure 3 schematically depicts use of an optical sensor of the sensor system of Figure 2;
- Figures 4A and 4B schematically depict a measurement performed according to an embodiment of the invention which is used to measure contamination on the optical sensor;
- Figures 5A and 5B schematically depict a measurement performed according to another embodiment of the invention which is used to measure contamination on the optical sensor;
- Figures 6A and 6B schematically depict a measurement performed according to another embodiment of the invention which is used to measure contamination on the optical sensor;
- Figure 7 is a graph which shows a signal that will be output from the optical sensor when a method according to an embodiment of the invention is used; and
- Figure 8 to 10 schematically depict a measurements according to embodiments of the invention;
- Figure 11 depicts contamination with four different cross-sectional shapes; and
- Figure 12 depicts resulting signals of an embodiment of the invention for those four cross-sectional shapes.

## DETAILED DESCRIPTION

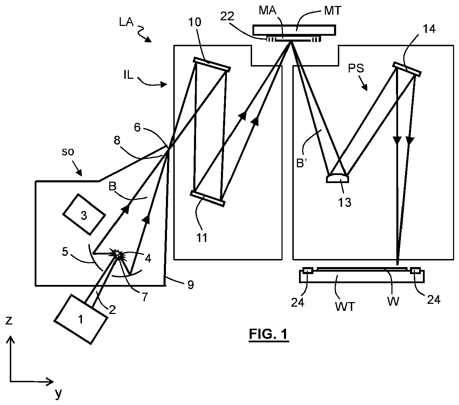

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

During a scanning exposure, the patterning device MA and support structure MT move in the y-direction, and the substrate W and substrate table WT move in the opposite y-direction. In this way, a band of EUV radiation passes over an exposure field on the substrate W.

The substrate W may include previously formed patterns. Where this is the case, the lithographic apparatus LA aligns the image, formed by the patterned EUV radiation beam B', with a pattern previously formed on the substrate W. The positions of alignment marks on the substrate table are measured with respect to the position of alignment marks 22 on the patterning device MA. This is done using sensor systems 24 which include alignment marks. This alignment of the patterning device MA with respect to the substrate table WT allows the patterning device to be aligned with the substrate W. The alignment marks 22 may comprise various different shapes and/or patterns. At least some of the patterns may be gratings.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a $CO_2$ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

Contamination will build up on sensors of the sensor system 24. In one example, contamination build up on an optical sensor of the sensing system may cause the optical sensor to provide an inaccurate output. This in turn may cause poor alignment of a projected pattern with respect to a pattern already present on a substrate W. Embodiments of the invention address this issue.

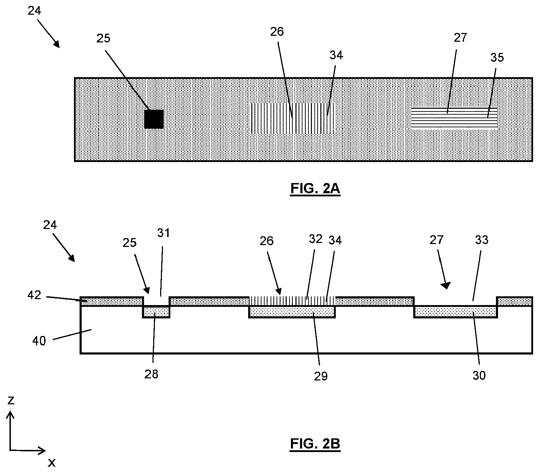

Figures 2A and 2B schematically depict the sensor system 24 which is provided on the substrate table W. Figure 2A depicts the sensor system viewed from above, and Figure 2B depicts the sensor system in cross section. The sensor system 24 comprises optical sensors 25-27 of different sizes. The sensor system 24 may include other optical sensors.

The sensor system 24 comprises a substrate 40 within which detectors 28-30 are formed. A layer of opaque material 42 is provided on the substrate, and apertures 31-33 are formed in the opaque material above the detectors 28-30. The size of each aperture 31-33 controls the amount of EUV radiation which is incident on each detector 28-30. The sensor system 24 may comprise semiconductors and may be formed using lithography.

A first optical sensor 25 has a square shape when viewed from above, and comprises a detector 28 (e.g. photodiode) surrounded by an aperture 31. The first optical sensor 25 may for example have an area of around $50 \times 50um^2$. The shape of the optical sensor 25 may be defined by the aperture 31. As discussed further below, although the optical sensor in this embodiment is square, the optical sensor may have any shape.

A second optical sensor 26 comprises a detector 29 (e.g. photodiode) surrounded by an aperture 32. A grating 34 is formed in the layer of opaque material 42. The grating 34 extends in the X-direction.

A third optical sensor 27 comprises a detector 30 (e.g. photodiode) surrounded by an aperture 33. A grating 35 which is formed in the layer of opaque material 42. The grating 35 extends in the Y-direction. This grating 35 is not depicted in Figure 2B in order to avoid complicating the drawing.

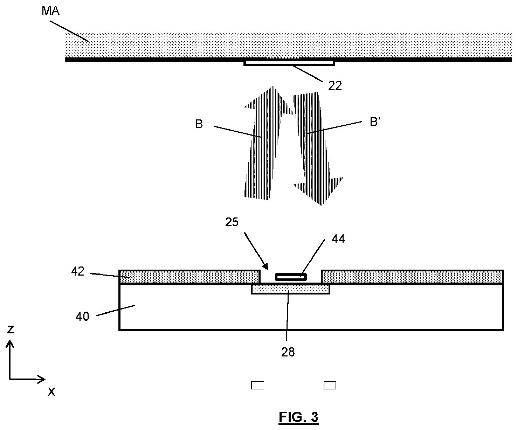

In use, the optical sensors 25-27 may be used to ensure alignment of the patterning device MA with the substrate table W (see Figure 1). The manner in which this is achieved is illustrated schematically in Figure 3. The EUV radiation beam B is used to by illuminate an alignment mark 22 on the patterning device MA. The resulting patterned beam B' is project by the projection system PS (see Figure 1) to form an aerial image 44 of the alignment mark 22. The projection system PS typically includes a reduction factor, and as a result the aerial image 44 may be smaller than the alignment mark 22. The aerial image 44 is formed above (or on) the detector 28 of the first optical sensor 25. Although only one alignment mark and optical sensor is depicted in Figure 3, the same method is used for other alignment marks and optical sensors.

When aligning the patterning device MA relative to the substrate WT, the alignment may be performed in two parts. In a first part a so-called coarse-align is performed. In the coarse-align the substrate table WT is moved by a considerable distance in a scanning movement, typically a few hundred microns (e.g. 200 microns), such that the first alignment mark aerial image 44 passes fully across the first detector 28. The alignment mark may be referred to as a capture mark, because it allows the coarse position of the substrate table WT with respect to the patterning device MA to be 'captured'. The capture mark 40 may be a square. However, the alignment mark may have any shape. Similarly, although the first detector 28 is square, it may have any shape. The detector 28 should have an area which is greater than the area of the alignment mark aerial image. At the same time that the capture mark aerial image passes over the first detector 28, multiple periods of an aerial image of an X-direction grating pass over the X-direction grating detector 29.

The substrate table WT is then moved diagonally (in the +X and -Y directions). Following this, the substrate table WT is moved with a scanning movement in the Y-direction, typically by hundreds of microns (e.g. 200 microns). As a result, the capture mark aerial image 44 passes fully over the first detector 28 in the Y-direction. A Y-direction grating aerial image passes over multiple periods of the Y-direction grating detector 30.

The coarse-align allows the position of the substrate table to be determined with an accuracy of around a few tens of nanometers or better. Following this, the second alignment process is performed. The second alignment process may be referred to as a fine-align. In the fine-align, the substrate table is positioned such that the capture mark aerial image 44 is positioned centrally over the first detector 26, and X and Y direction grating aerial images are also centrally positioned with respect to the X and Y grating detectors 29, 30. A small movement, typically up to 2 microns in a diagonal direction, is then performed. The resulting signal from the X and Y grating detectors 29, 30 indicates the relative positions of the aerial images of the gratings and the X and Y grating detectors 29, 30. This signal may be used to align the substrate table WT to the patterning device MA with an accuracy of a nanometer or with sub-nanometer accuracy.

The sensor system 24 may also be used to ensure that the substrate table W has the correct Z-direction position with respect to the focal plane of the projection system PS of the lithographic apparatus. For this, the substrate table WT and sensor system 24 may be moved in the Z-direction by a distance of around 100 microns. The Z-direction position may be determined with an accuracy of a few nanometers or better.

During the coarse-align and the fine align, the alignment marks on the patterning device MA are illuminated by the EUV radiation beam B, and as a result EUV radiation is incident upon the sensor system 24. This generates contamination due to interaction between the EUV radiation and gas molecules or other contaminants in the vicinity of the sensor system 24. During the fine align, as noted above, the aerial image of the capture mark 44 is centrally located over the first detector 28. During the coarse-align the substrate table WT and sensor system 24 are moved in a scanning motion beneath the aerial images of the marks. However, this movement is relatively quick, and the exposure to EUV radiation caused by this movement is relatively low and does not generate significant contamination. As a result, EUV radiation is consistently incident upon a central area of the first detector 28, and contamination builds up in the central areas. The contamination has the shape of the aerial image of the capture mark 44 as projected during the fine align. The same applies for other marks and detectors of the sensor system 24. The area of the aerial image of the capture mark 44 is smaller than the area of the first detector 28. As a result, part of the area of the first detector 28 does not receive a build-up of contamination in the shape of the aerial image 44. The same applies for other marks and detectors of the sensor system.

Embodiments of the invention measure a thickness of the centrally formed contamination (i.e. contamination that has built up in central areas of the detectors). The combination on a detector of a contaminated area and an uncontaminated area allows the thickness of the contamination to be measured. The combination of a contaminated area and an uncontaminated area arises from the aerial image of an alignment mark being smaller than the area of the detector which detects that alignment mark. Measuring the thickness of the contamination advantageously allows for the sensor system 24 to be cleaned when the contamination thickness is such that cleaning is required. This is better than estimating the contamination thickness based upon an accumulated dose of EUV radiation projected onto the sensor system 24 and cleaning the contamination based on that estimate, because using an estimate can result in cleaning being performed when it is not required.

In some embodiments, the contamination may have a known effect upon the output signal provided by a sensor of the sensor system. For example, for the Z-direction position measurement, a certain thickness of contamination may result in a known offset of the measured position from the actual position. This offset may be taken into account in order to determine the actual position. Thus, in some embodiments, measuring the thickness of the contamination enables correction of a measurement error. In some embodiments, instead of correcting a measurement error, the effect of the measurement error may be taken into account when adjusting the lithographic apparatus. For example, if it is known that that the detector output is offset by a particular amount when a certain thickness of contamination is present, an adjustment of the lithographic apparatus may be performed based upon a combination of the detector output and the known offset.

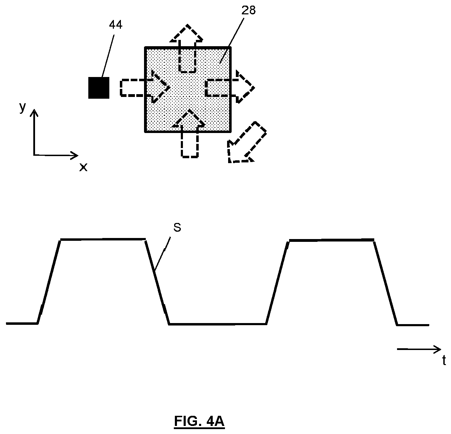

Figure 4A schematically depicts scanning movement of the first detector 28 beneath the aerial image of the capture mark 44 during a coarse-align, and schematically depicts a signal S output from the first detector 28 when this is done. Other movements of the first detector 28 may be used to obtain an output signal (as explained further below). The signal S is proportional to the intensity I of light detected by the detector 28 as a function of time t. As depicted, the aerial image 44 starts outside of the area of the detector 28, and the signal from the first detector 28 is zero. The aerial image 44 moves in X-direction, as schematically depicted by the dashed arrows. As the aerial image 44 overlaps the detector 28, the output signal increases linearly. The output signal reaches a maximum when the aerial image 44 is fully over the detector 28. The output signal remains at the maximum value until the aerial image 44 of the capture mark starts to move off the detector 28 (i.e. the overlap between the aerial image and the detector 28 starts to reduce). The signal falls to zero. The detector 28 is then moved diagonally (as indicated by the dashed arrow), until the aerial image 44 is aligned with the detector 28 in the X-direction but separated from the detector in the Y-direction. A Y-direction scan is then performed. This generates the same output signal.

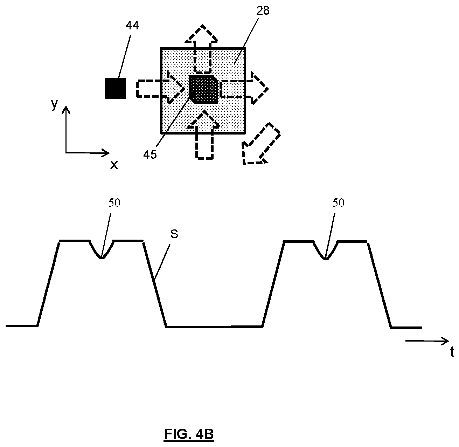

Figure 4B illustrates schematically a signal output from the detector 28 when contamination is present on the detector. Figure 4B also schematically illustrates contamination on the detector 28, the contamination being depicted as a dark area 45 in the centre of the detector. The dark area 45 is slightly larger than the aerial image 44 of the capture mark. This is because, as explained further above, during the fine alignment some movement of the detector 28 with respect to the aerial image 44 takes place. This movement provides a small amount of spread of the contamination 45.

in Figure 4B, the coarse-alignment scan again starts with an X-direction scan and is then followed by a Y-direction scan. During the X-direction scan, the signal begins at zero, and rises to a maximum once the entire aerial image 44 is over the detector 28. However, the output signal then decreases when the aerial image 44 starts to overlap with the contamination 45. This is because the contamination 45 absorbs EUV radiation and thus less EUV radiation is incident upon the detector 28. The output signal continues to fall and reaches a minimum when the aerial image 44 is fully over the contamination 45. The signal starts to increase as the aerial image 44 moves away from the contamination 45, and the signal again reaches a maximum when the aerial image is fully over a non-contaminated portion of the detector 28. The signal then gradually reduces to zero as the aerial image moves off the detector 28.

The coarse-alignment scan is then performed in the Y-direction, generating the same output signal (as depicted).

In embodiments of the invention, the presence of a minimum 50 in the output signal is used to identify that contamination is present. The depth of the minimum 55 indicates the thickness of contamination 45 present on the detector 28. The depth of the minimum 55 can be used to determine when the thickness of contamination present on the detector 28 has reached a threshold amount, such that cleaning of the detector is required. The threshold may be identified for example by determining that the depth of the minimum 50 has reached a threshold value.

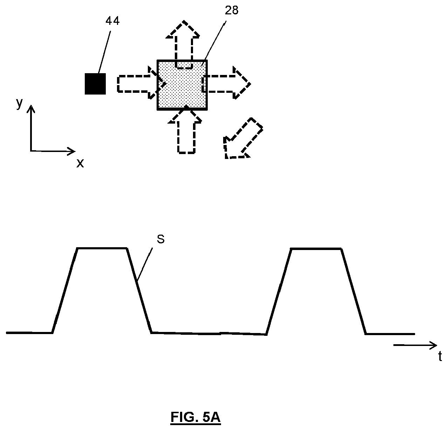

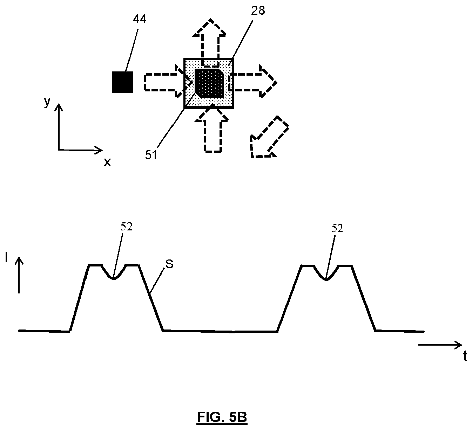

In the embodiment depicted in Figures 4A and 4B, the size of the detector is such that the entire aerial image 44 of the alignment mark (in this case the capture mark) may be incident upon an area of the detector 28 which has no significant contamination. However, embodiments of the invention can also accommodate the situation in which this is not the case. Such an embodiment is depicted in Figures 5A and 5B. As depicted, the detector 51 is smaller than the detector depicted in Figures 4A and 4B. The aerial image 44 of the capture mark is the same size as depicted in Figures 4A and 4B.

Referring to Figure 5A, when no contamination is present, the signal output from the detector 24 is equivalent to the signal seen in Figure 4A. In particular, signal has a flat central middle portion for the X-direction scan and for the Y-direction scan.

Figure 4B schematically illustrates contamination on the detector 28, the contamination being depicted as a dark area 51 in the centre of the detector. For the reason explained above, the area of contamination 51 is slightly larger than the aerial image 44 of the capture mark (although embodiments of the invention would also work if the contamination area was the same size or smaller than the aerial image).

In Figure 5B, the maximum signal output from the detector 28 is lower than the maximum signal seen in Figure 5A. This is because there is no position of the capture mark aerial image 44 with respect to the detector 51 which provides a full signal from the detector (there is always some overlap with contamination or part of the aerial image does not overlap with the detector). However, the output signal passes through a minimum 52 when the aerial image passes over the contaminated area 51 of the detector 28, as is schematically depicted in Figure 5B. As with the embodiment of Figure 4B, the presence of the minimum 52 can be used to determine that contamination is present. The depth of the minimum 52 may be used to measure the thickness of the contamination 51. A threshold minimum depth may be set, or some other threshold characteristic. When this threshold is exceeded cleaning of the detector 28 may be performed.

The above embodiments use a scanning movement of the detector 28 relative to the aerial image into perpendicular directions. However, in other embodiments a scanning movement of the detector 28 in a single direction may be used to measure contamination of the detector.

References in this document to movement of the detector 28 may be interpreted as referring to movement of the sensor system 24.

The above embodiments use scanning movement of the detector 28 relative to the aerial image 44. However, the detector 28 may instead be stepped between different positions with respect to the aerial image 44. This may be done for example when it is desired to obtain individual measurements of higher accuracy. When a detector 28 remains in position for a period of time, instead of moving continuously as with a scan, more photons will be incident upon the detector. This provides a higher signal to noise ratio, and thus a more accurate measurement. The general shape of the signal that will be seen, as a function of X and Y position of the detector 28, does not change significantly and so is already known. This means that the positions of the stepped measurements (which may also be referred to as discrete measurements) may be selected to provide sufficient data to accurately characterise the shape of the signal output from the detector 28. For example, the positions of the measurements may be selected to allow the dip 50, 52 to be characterised.

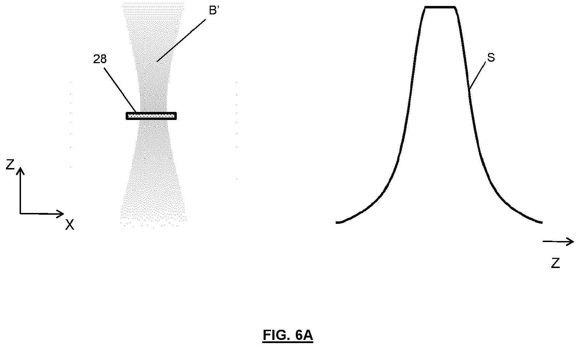

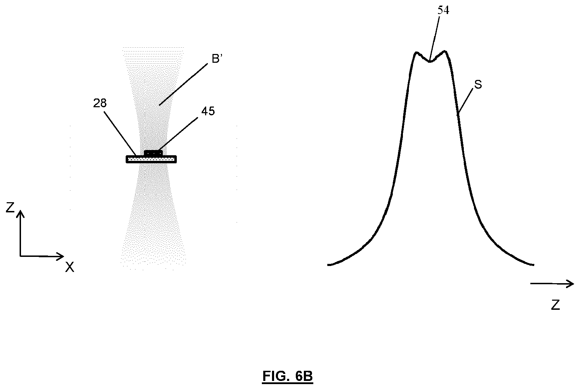

Figures 6A and 6B schematically depict an alternative embodiment of the invention. Referring first to Figure 6A, the effect of moving the detector 28 in the Z-direction when the aerial image is aligned with the centre of the detector is schematically depicted. The detector 28 is schematically depicted in the focal plane of the projection system. The patterned EUV radiation beam B' which carries the aerial image is also schematically depicted. The patterned radiation beam B' has a minimum diameter at the focal plane of the projection system. When the detector 28 lies in the focal plane, an aerial image of the alignment mark is in focus at the detector. As the detector 28 moves in the Z-direction away from the focal plane, the alignment mark image becomes less and less focused. That is, the alignment mark image is spread over a larger and larger distance.

Figure 6A schematically depicts a signal S output from the detector 28 when the detector is moved in the Z-direction (from below the focal plane to above the focal plane). The detector 28 starts below the focal plane, and thus the projected image of the capture mark is out of focus. As a result the EUV radiation is spread out, and some of the EUV radiation lies outside of the detector 28. As the detector 28 moves towards the focal plane of the projection system, the aerial image of the capture mark becomes focussed and thus smaller. The amount of EUV radiation incident upon the detector 28 increases, and the signal S increases. When the aerial image of the capture mark is close to being in focus, all of the EUV radiation is incident upon the detector, and the output signal S reaches a maximum. The signal S remains at the maximum whilst the image of the alignment mark fully overlies the detector 28. The signal once again decreases as the detector 28 moves away from the focal plane and part of the EUV radiation falls outside of the detector.

Referring to Figure 6B, when contamination 45 is present on the detector 28, a minimum 54 is seen in the signal S output from the detector. The presence of the minimum 54 indicates the presence of contamination 45 on the detector 28. The depth of the minimum 54 indicates the thickness of contamination present on the detector 28. A threshold depth of the minimum 54 may be set. When the threshold is reached the detector 28 may be cleaned. As with other embodiments, this embodiment may be used to measure the thickness of contamination, irrespective of whether the contamination area is larger, smaller, or the same size as the area of the aerial image. The contamination area should be smaller than the area of the detector.

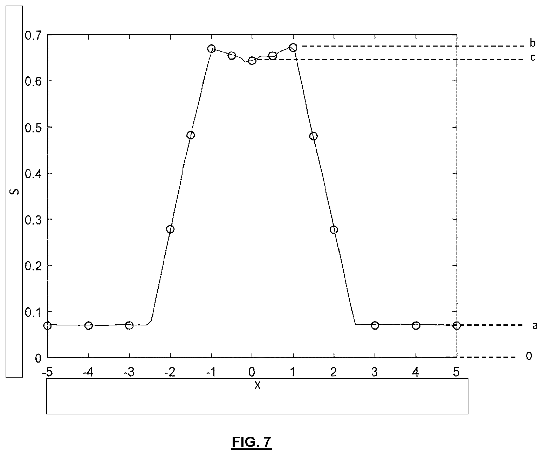

Figure 7 is a graph which shows a signal that will be output from the detector 28 when the method depicted in Figure 4B is performed. The vertical axis of the graph shows the power S measured by the detector, and the horizontal axis shows the X-direction position of the detector. The line shows the result of a scanning measurement (i.e. continuous measurement whilst the detector 28 is being moved). The circles show the result of individual (discrete) measurements.

As will be appreciated from Figure 7, the discrete measurements are sufficient to characterise the shape of the signal S.

A mathematical formula can be used to characterise the signal, and thus allow a measurement of the thickness of the contamination on the detector. In the mathematical formula it is assumed that the detector is square and the alignment mark is square. The following symbols are used:

S: power measured by the detector
D: length of a side of the detector;
*m:* length of a side of the aerial image of the alignment mark;
*k:* length of a side of the contamination (it is assumed for simplicity that the contamination is generally square even though the shape of the contamination may deviate from this, i.e. *k* is within a few percent of m)
*I:* EUV power per unit area incident at the patterning device MA (values are relative values and so power does not need to be in Watts).
$R_M$: alignment mark reflectivity (which may be for example around 65%)
$R_{abs}$: reflectivity of the absorber area which surrounds the alignment mark (which may be for example 2%)
b: maximum signal measured by sensor
*c:* dip in signal in the middle of the scan (aerial image of alignment mark is fully over the contamination)
*a:* background signal when aerial image does not overlap with the detector *cont:* signal loss due to contamination (which may be a few %)

For simplicity, it is assumed here that the contamination layer has uniform thickness (constant profile) over the contaminated area. However, the embodiments of the invention also work in cases in which the contamination is not uniform (as explained further below).

EUV power per unit area I as expressed above is the power incident at the patterning device MA. Transmission of the EUV radiation by the projection system PS (see Figure 1) of the lithographic apparatus will reduce the power per unit area. However, this transmission loss may be ignored in calculations used by the invention because it is constant and cancels out in the calculations (the same applies to I).

The signal loss due to contamination *cont* can be converted to a contamination thickness when the relationship between the contamination thickness and the signal loss is known. For example, a signal loss of around 0.5% per nanometer thickness of contamination may occur. In such a case, if a signal loss *cont* of 60% is seen, then this would correspond with a contamination thickness of around 120 nm.

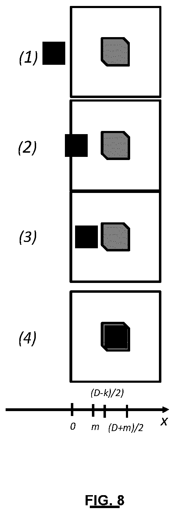

Figure 8 depicts a measurement when detector 28 is sufficiently large that the aerial image 44 of the alignment mark may be fully incident upon a non-contaminated area of the detector 28. A formula characterising the power S measured by the detector for each position of the aerial image is set out below. In Figure 8 the reflectivity of the absorber $R_{abs}$ is set to zero, and as a result no background signal *a* is seen. The formulae are:

$$\text{Position (1)} \qquad S(x < 0) = a = 0$$

$$\text{Position (2)} \qquad S(x < m) = R_m \cdot I \cdot (m \cdot x)$$

$$\text{Position (3)} \qquad S\left(x < \frac{D-k}{2}\right) = R_m \cdot I \cdot m^2 = b$$

$$\text{Position (4)} \qquad S\left(x \sim \frac{D+m}{2}\right) = R_m \cdot I \cdot m^2 \cdot (1 - cont) = c$$

For the scenario depicted in Figure 8, the formulae may be simplified to:

$$cont = 1 - \frac{c}{b} \qquad\qquad \text{Equation 1}$$

In Equation 1 the size of the dip c is normalised by dividing it by the maximum signal *b*. When no dip is present, the fraction c/b is 1, and so the value of cont is 0. When the dip c is present, a relatively small value of c indicates a relatively large thickness of contamination (a relatively small value of c indicates that a relatively small intensity of light is measured by the detector 28). A relatively large value of c indicates a relatively small thickness of contamination (a relatively large value of c indicates the a relatively large intensity of light is incident upon the detector 28). The value of cont provides a direct characterisation of the thickness of the contamination.

In a modified scenario, the detector 28 is sufficiently large that the aerial image 44 of the alignment mark may be fully incident upon a non-contaminated area of the detector 28, but the reflectivity of the absorber $R_{abs}$ is not zero. Because $R_{abs}$ is not zero, a background signal $a$ is seen (in practice some background signal will generally be seen).

For this scenario, the following equation characterises the contamination *cont:*

$$cont = 1 - \frac{(c - Sa \cdot a)}{(b - Sa \cdot a)} \qquad \text{Equation 2}$$

where $Sa = \frac{(D^2 - m^2)}{D^2}$ . Equation 2 characterises the dip in a similar way to Equation 1, but takes into account the presence of the background signal a. The value of *cont* provides a direct characterisation of the thickness of the contamination (without making an approximation that there is no background signal).

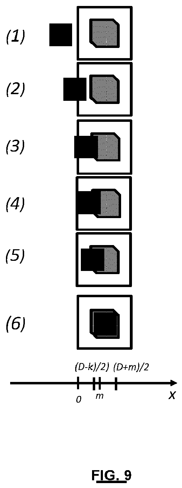

Figure 9 depicts a measurement when detector 28 is smaller, such that the aerial image 44 of the alignment mark cannot be fully incident upon a non-contaminated area of the detector 28. In Figure 9, the reflectivity of the absorber $R_{abs}$ is zero, and as a result no background signal $a$ is seen.

For the scenario depicted in Figure 9, the following equation characterises the contamination *cont:*

$$cont = 1 - \frac{c \cdot \left(\frac{D-k}{2}\right)}{\left[b \cdot m + c \cdot \left(\frac{D-k}{2} - m\right)\right]} \qquad \text{Equation 3}$$

The value of *cont* provides a direct characterisation of the thickness of the contamination, but with approximation that there is no background signal.

The size of the dip can be characterised in other ways. For example a polynomial curve may be fitted to the output signal. Any form of curve-fitting or other characterisation may be used. The dip may be referred to as a minimum.

Embodiments of the invention use a square alignment mark and a square detector. However, the alignment mark and the detector may have any shape. The aerial image of the alignment mark should be smaller than the detector, such that during alignment measurements when small or negligible movements of the detector occur, some of the area of the detector is not illuminated by the alignment mark. As a result, part of the area of the detector receives contamination and part of the area of the detector does not receive contamination. It is this combination of contaminated and uncontaminated areas which is advantageously used by embodiments of the invention to measure the thickness of the contamination. The detector and alignment mark do not need to be a single solid shape (e.g. square, rectangle, circle). The detector and the alignment mark may have a complex shape such as a chessboard arrangement (i.e. an array of squares).

In described embodiments of the invention, the aerial image which is used when measuring contamination thickness is the same shape and size as the aerial image which is used during alignment measurements. However, the aerial image which is used when measuring contamination thickness may have a different shape and/or size than the aerial image which is used during alignment measurements. The aerial image which is used when measuring contamination thickness may have an area which is greater than the area of the detector. However, the aerial image which is used when measuring contamination thickness should still move through positions which provide different amounts of overlap between the aerial image and the detector.

In the above described embodiments it has been assumed that the contamination has a uniform thickness. However, the contamination may have a non-uniform thickness. Embodiments of the invention may characterise the thickness variation of the contamination.

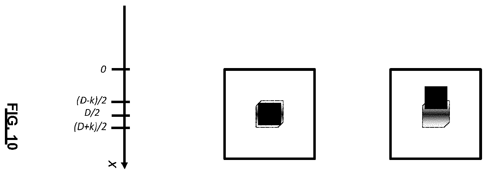

Figure 10 schematically depicts a scenario in which the contamination has a non-uniform thickness. In Figure 10, the aerial image is intially partially overlapping with the contamination. In this situation, the signal output from the detector may be expressed as:

$$S\left(x > \frac{D-k}{2}\right) = R_m \cdot I \cdot m \cdot \left[m - \int_{\frac{D-k}{2}}^{x} cont(\rho)d\rho\right] \qquad \textit{Equation 4}$$

The aerial image is then fully overlapping with the contamination. In this situation, the signal output from the detector may be expressed as:

$$S\left(x > \frac{D-k}{2} + m\right) = R_m \cdot I \cdot m \cdot \left[m - \int_{x-m}^{x} cont(\rho)d\rho\right] \qquad \textit{Equation 5}$$

Other positions where the aerial image does not overlap with the contamination may be expressed as further above in connection with Figure 8.

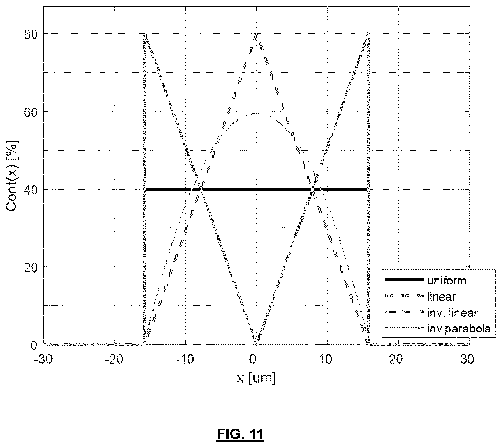

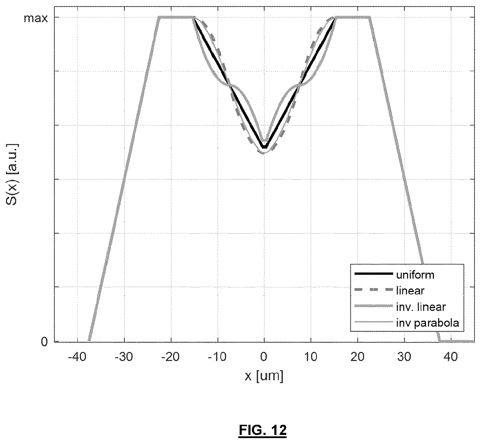

Figure 11 depicts contamination having four different cross-sectional shapes. These are referred to as uniform, linear, inverse linear, and inverse parabola. Figure 12 shows the signal that will be seen for each contamination cross-sectional shape (calculated using the above equations). As may be seen from Figure 12, the signal has a different curve shape for each contamination cross-sectional shape (although the curve shapes for linear and invers parabola are very similar).

Embodiments of the invention may analyse the shape of the signal to obtain information about the cross-sectional shape of the contamination. The shape of the signal may for example be determined using conventional curve-fitting. Knowing the cross-sectional shape of the contamination may advantageously allow the manner in which cleaning is performed to be selected accordingly.

When it is desired to obtain information about the cross-sectional shape of the contamination, measurements of the detector output may be performed with a higher accuracy than when it is merely desired to measure the general thickness of the contamination (and/or more measurements may be performed). In other words, when a characterisation of the shape of the signal is desired then higher accuracy measurements and/or more measurements may be performed compared with when it is desired to determine the depth of the dip in the signal.

A signal output from a detector when an embodiment of the invention is used will be self-consistent. That is, the signal depends on the geometry of the alignment mark (and may also depend upon the geometry of the detector). The signal does not depend upon parameters such as alignment mark reflectivity which are likely to change over time (and may vary between different lithographic apparatus). Embodiments of the invention therefore allow comparison between measurements performed on the same optical sensor at different times. Embodiments of the invention also allow comparison of contamination measurements on different optical sensors, in the same or in different lithographic apparatus.

Embodiments of the invention can measure contamination using multiple different detectors in the same lithographic apparatus. This allows independent measurement of the thickness of the contamination for each of the detectors.

A method according to an embodiment of the invention may be performed by a computing device. The device may comprise a central processing unit ("CPU") to which is connected a memory. The method described herein may be implemented in code (software) stored on a memory comprising one or more storage media, and arranged for execution on a processor comprising on or more processing units. The storage media may be integrated into and/or separate from the CPU. The code, which may be referred to as instructions, is configured to be fetched from the memory and executed on the processor to perform operations in line with embodiments discussed herein. Alternatively it is not excluded that some or all of the functionality of the CPU is implemented in dedicated hardware circuitry, or configurable hardware circuitry like an FPGA. In general, the method may be performed by a processor.

The computing device may comprise an input configured to enable a user to input data into a software program running on the CPU. The input device may comprise a mouse, keyboard, touchscreen, microphone etc. The computing device may further comprises an output device configured to output results of measurements to a user.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Clause

1. A method of determining contamination of an optical sensor in a lithographic apparatus, the method comprising:

illuminating a pattern on a patterning device using EUV radiation;
projecting patterned reflected EUV radiation towards the optical sensor and thereby forming an aerial image of the pattern; and
moving the optical sensor relative to the patterned reflected EUV radiation such that an intensity of EUV radiation measured by the optical sensor varies as a function of the position of the optical sensor; wherein the intensity measured by the optical sensor passes through a minimum, and wherein the method further comprises using the measured intensity to measure contamination of the optical sensor.

2. The method of clause 1, wherein a depth of the minimum is used to measure the contamination of the optical sensor.

3. The method of clause 1, or clause 2, wherein the movement of the optical sensor is generally perpendicular to a direction of the projected EUV radiation.

4. The method of clause 3, wherein method further comprises using the shape of the measured intensity to obtain information about a cross-sectional shape of the contamination.

5. The method of clause 1, or clause 2, wherein the movement of the optical sensor is generally parallel to a direction of the projected EUV radiation.

6. The method of any preceding clause, wherein the optical sensor has an area which is greater than an area of the aerial image of an alignment pattern used to perform alignment measurements in connection with the optical sensor.

7. The method of clause 6, wherein the pattern which is illuminated for the contamination measurement is the alignment pattern.

8. The method of any preceding clause, wherein the measurement of the contamination takes into account an intensity of background radiation incident upon the optical sensor.

9. The method of any preceding clause, wherein the measured contamination is compared with a threshold value.

10. A lithographic apparatus comprising a patterning device support structure, a projection system, and a substrate table provided with an optical sensor; wherein the lithographic apparatus comprises a processor configured to move the sensing system relative to a projected patterned EUV radiation beam such that an intensity of EUV radiation measured by the optical sensor varies as a function of sensor position and includes a minimum, and wherein the processor is further configured to use the measured intensity to measure contamination of the optical sensor.

11. The lithographic apparatus of clause 10, wherein the processor is configured to use a depth of the minimum to measure the contamination of the optical sensor.

12. The lithographic apparatus of clause 10, or clause 11, wherein the movement of the optical sensor is generally perpendicular to a direction of the projected patterned EUV radiation beam.

13. The lithographic apparatus of clause 12, wherein the processor is configured to use the shape of the measured intensity to obtain information about a cross-sectional shape of the contamination.

14. The lithographic apparatus of clause 10, or clause 11, wherein the movement of the optical sensor is generally parallel to a direction of the projected EUV radiation.

15. The lithographic apparatus of any of clauses 10 to 14, wherein the optical sensor has an area which is greater than an area of an aerial image of an alignment pattern used to perform alignment measurements in connection with the optical sensor.

16. The lithographic apparatus of any of clauses 10 to 15, wherein the measurement of the contamination takes into account an intensity of background radiation incident upon the optical sensor.

17. The lithographic apparatus of any of clauses 10 to 16, wherein the measured contamination is compared with a threshold value.

18. A computer-readable storage medium comprising instructions which, when executed by a processor of a computing device cause the computing device to perform the method of any of clauses 1 to 9.

19. A computing device comprising a processor and memory, the memory storing instructions which, when executed by the processor cause the computing device to perform the method of any of clauses 1 to 9.

**Claims**

1. A method of determining contamination of an optical sensor in a lithographic apparatus, the method comprising:

   illuminating a pattern on a patterning device using EUV radiation;
   projecting patterned reflected EUV radiation towards the optical sensor and thereby forming an aerial image of the pattern; and
   moving the optical sensor relative to the patterned reflected EUV radiation such that an intensity of EUV radiation measured by the optical sensor varies as a function of the position of the optical sensor;
   wherein the intensity measured by the optical sensor passes through a minimum, and wherein the method further comprises using the measured intensity to measure contamination of the optical sensor.

2. The method of claim 1, wherein a depth of the minimum is used to measure the contamination of the optical sensor, or / and
   wherein the movement of the optical sensor is generally perpendicular to a direction of the projected EUV radiation.

3. The method of claim 2, wherein method further comprises using the shape of the measured intensity to obtain information about a cross-sectional shape of the contamination.

4. The method of claim 1, wherein the movement of the optical sensor is generally parallel to a direction of the projected EUV radiation.

5. The method of any preceding claim, wherein the optical sensor has an area which is greater than an area of the aerial image of an alignment pattern used to perform alignment measurements in connection with the optical sensor.

6. The method of claim 5, wherein the pattern which is illuminated for the contamination measurement is the alignment pattern.

7. The method of any preceding claim, wherein the measurement of the contamination takes into account an intensity of background radiation incident upon the optical sensor or / and
   wherein the measured contamination is compared with a threshold value.

8. A lithographic apparatus comprising a patterning device support structure, a projection system, and a substrate table provided with an optical sensor; wherein the lithographic apparatus comprises a processor configured to move the optical sensor relative to a projected patterned EUV radiation beam such that an intensity of EUV radiation measured by the optical sensor varies as a function of sensor position and includes a minimum, and wherein the processor is further configured to use the measured intensity to measure contamination of the optical sensor.

9. The lithographic apparatus of claim 8, wherein the processor is configured to use a depth of the minimum to measure the contamination of the optical sensor, or / and
   wherein the movement of the optical sensor is generally perpendicular to a direction of the projected patterned EUV radiation beam.

10. The lithographic apparatus of claim 9, wherein the processor is configured to use the shape of the measured intensity to obtain information about a cross-sectional shape of the contamination.

11. The lithographic apparatus of claim 8, wherein the movement of the optical sensor is generally parallel to a direction of the projected EUV radiation.

12. The lithographic apparatus of any of claims 8 to 11, wherein the optical sensor has an area which is greater than an area of an aerial image of an alignment pattern used to perform alignment measurements in connection with the optical sensor or / and

wherein the measurement of the contamination takes into account an intensity of background radiation incident upon the optical sensor.

13. The lithographic apparatus of any of claims 8 to 12, wherein the measured contamination is compared with a threshold value.

14. A lithographic apparatus comprising a patterning device support structure, a projection system, and a substrate table provided with an optical sensor; wherein the lithographic apparatus comprises a processor

15. A system for measuring contamination of an optical sensor for a lithographic apparatus, comprising: the optical sensor, and a processor configured to move the optical sensor relative to a projected patterned EUV radiation beam such that an intensity of EUV radiation measured by the optical sensor varies as a function of sensor position and includes a minimum, and wherein the processor is further configured to use the measured intensity to measure contamination of the optical sensor.

FIG. 1

24

25          26     34          27     35

**FIG. 2A**

24

25  31          26  32 34          27  33

42

40

28          29          30

Z

X

**FIG. 2B**

MA

22

B          B'

25          44

42

40          28

Z

X

FIG. 3

**FIG. 4A**

**FIG. 4B**

**FIG. 5A**

FIG. 5B

**FIG. 6A**

B'

28

45

Z

X

54

S

Z

**FIG. 6B**

**FIG. 7**

**FIG. 8**

(1)

(2)

(3)

(4)

(5)

(6)

(D-k)/2)  (D+m)/2

0    m                    X

**FIG. 9**

**FIG. 10**

**FIG. 11**

**FIG. 12**

Europäisches
Patentamt

European
Patent Office

Office européen
des brevets

# EUROPEAN SEARCH REPORT

**Application Number**

EP 22 18 8166

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/101838 A1 (CHEN ZI-WEN [TW] ET AL) 4 April 2019 (2019-04-04) | 14 | INV. G03F7/20 G03F9/00 |
| A | * paragraphs [0012] - [0039], [0043] - [0044]; figures 1A,1B, 2A * | 1-13,15 | |
| A | EP 1 452 851 A1 (ASML NETHERLANDS BV [NL]; ZEISS CARL SEMICONDUCTOR MFG [DE]) 1 September 2004 (2004-09-01) * paragraphs [0026] - [0046]; figures 3-6 * | 1-15 | |
| A | WO 2009/128717 A1 (ASML NETHERLANDS BV [NL]; ZEISS CARL SMT AG [DE] ET AL.) 22 October 2009 (2009-10-22) * paragraphs [0008] - [0010], [0056] - [0063]; figures 1, 2, 3a * | 1-15 | |

TECHNICAL FIELDS
SEARCHED        (IPC)

G03F

The present search report has been drawn up for all claims

| Place of search | Date of completion of the search | Examiner |
|---|---|---|
| Munich | 19 January 2023 | Eisner, Klaus |

EPO FORM 1503 03.82 (P04C01)

## ANNEX TO THE EUROPEAN SEARCH REPORT
## ON EUROPEAN PATENT APPLICATION NO.

EP 22 18 8166

This annex lists the patent family members relating to the patent documents cited in the above-mentioned European search report.
The members are as contained in the European Patent Office EDP file on
The European Patent Office is in no way liable for these particulars which are merely given for the purpose of information.

19-01-2023

| Patent document cited in search report | | Publication date | Patent family member(s) | | Publication date |
|---|---|---|---|---|---|
| US 2019101838 | A1 | 04-04-2019 | CN | 109581818 A | 05-04-2019 |
| | | | TW | 201915617 A | 16-04-2019 |
| | | | US | 10534279 B1 | 14-01-2020 |
| | | | US | 2019101838 A1 | 04-04-2019 |
| | | | US | 2020150550 A1 | 14-05-2020 |
| EP 1452851 | A1 | 01-09-2004 | NONE | | |
| WO 2009128717 | A1 | 22-10-2009 | CN | 102037408 A | 27-04-2011 |
| | | | JP | 5377627 B2 | 25-12-2013 |
| | | | JP | 2011517135 A | 26-05-2011 |
| | | | KR | 20110020771 A | 03-03-2011 |
| | | | TW | 201007367 A | 16-02-2010 |
| | | | US | 2011037961 A1 | 17-02-2011 |
| | | | WO | 2009128717 A1 | 22-10-2009 |

EPO FORM P0459

For more details about this annex : see Official Journal of the European Patent Office, No. 12/82